Europäisches Patentamt

European Patent Office

Office européen des brevets

(19)

(11) **EP 0 916 186 B1**

(12) **FASCICULE DE BREVET EUROPEEN**

(45) Date de publication et mention
de la délivrance du brevet:
**13.12.2000 Bulletin 2000/50**

(21) Numéro de dépôt: **97932881.2**

(22) Date de dépôt: **10.07.1997**

(51) Int Cl.7: **H03K 17/94**, H03K 17/687

(86) Numéro de dépôt international:
**PCT/FR97/01258**

(87) Numéro de publication internationale:
**WO 98/05123 (05.02.1998 Gazette 1998/05)**

(54) **Circuit intégré avec circuit résonant comportant une capacité ajustable par commutateur programmable**

Integrierte Schaltung mit einem eine durch einen programmierbaren Schalter einstellbare Kapazität aufweisenden Resonanzkreis

Integrated circuit with resonant circuit using a capacitance adjustable by means of a programmable switch

(84) Etats contractants désignés:
**AT BE CH DE ES FR GB IT LI NL**

(30) Priorité: **31.07.1996 FR 9609910**

(43) Date de publication de la demande:
**19.05.1999 Bulletin 1999/20**

(73) Titulaire: **Inside technologies**
**69930 Saint-Clément-les-Places (FR)**

(72) Inventeurs:
• **KOWALSKI, Jacek**
**F-13530 Trets (FR)**
• **MARTIN, Michel**
**F-13840 Rognes (FR)**

(74) Mandataire: **Marchand, André**
**OMNIPAT,**
**24 Place des Martyrs de la Résistance**
**13100 Aix-en-Provence (FR)**

(56) Documents cités:
**EP-A- 0 281 142        EP-A- 0 615 136**
**DE-A- 2 851 789        US-A- 4 814 640**

• **PATENT ABSTRACTS OF JAPAN vol. 016, no. 227 (E-1207), 26 mai 1992 & JP 04 042615 A (KAWASAKI STEEL CORP), 13 février 1992,**
• **PATENT ABSTRACTS OF JAPAN vol. 018, no. 349 (P-1763), 30 juin 1994 & JP 06 084384 A (SONY CORP), 25 mars 1994,**

**Description**

La présente invention concerne la connexion de composants électriques dans les circuits intégrés.

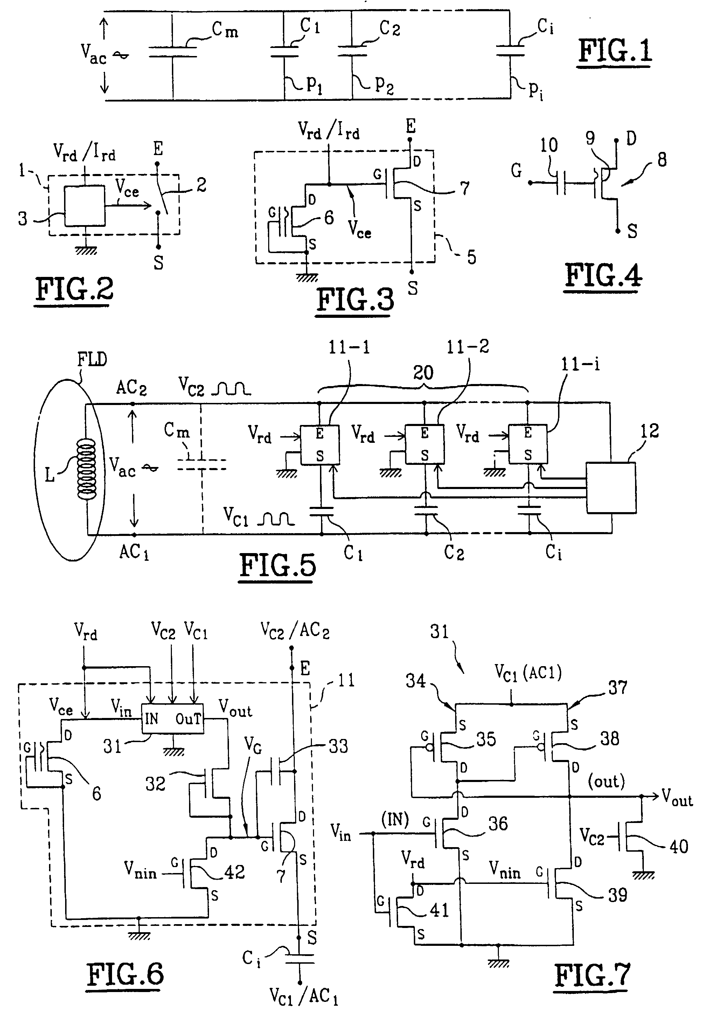

Dans les circuits intégrés, ou puces électroniques, certains composants électriques comme des capacités, des résistances ou tout autre élément passif ou actif participant au fonctionnement du circuit doivent parfois être calibrés avec précision. Une telle précision ne peut être obtenue au stade de la fonderie et ces composants sont donc ajustés finement après la fabrication des puces. La figure 1 illustre une méthode classique pour ajuster, par exemple, une capacité. En parallèle avec une capacité primaire Cm sont prévues des capacités d'ajustage C1, C2,..Ci de plus faible valeur, l'ensemble formant une capacité équivalente égale à la somme des capacités Cm, C1, C2,...Ci. Une fois la puce fabriquée, la capacité équivalente est ajustée finement en sectionnant au moyen d'un faisceau laser une ou plusieurs pistes conductrices p1, p2,...pi reliant les capacités d'ajustage à la capacité primaire.

Cette méthode présente l'inconvénient d'être lourde à mettre en oeuvre, de nécessiter des moyens de test et des machines d'un coût élevé et un temps de main d'oeuvre important.

Un autre inconvénient de cette méthode est que, pour des raisons de manutention, le sectionnement des pistes conductrices est réalisé lorsque les puces sont encore présentes collectivement sur la plaquette mère de silicium, appelée "wafer". Or, à ce stade, certains éléments devant parfois être pris en compte pour l'ajustage ne sont pas encore connectés aux puces. Notamment, une puce électronique d'une carte à puce sans contact ou d'une étiquette électronique alimentée par induction électromagnétique comporte un circuit de type LC (inductif-capacitif) dont la fréquence de résonance doit être accordée à la fréquence d'oscillation d'un champ magnétique inducteur permettant à la puce de fonctionner. Comme la bobine L du circuit LC est généralement soudée à la puce au dernier stade de la fabrication, l'ajustement de la capacité C sur le wafer ne permet pas de compenser les tolérances de fabrication de la bobine L et d'obtenir la valeur LC idéale. De plus, ne sont pas prises en compte diverses capacités parasites qui apparaissent lorsque la puce est sous tension.

Dans l'art antérieur, l'abrégé japonais JP6084384 décrit un circuit d'horloge dont la base de temps est déterminée par des capacités en parallèle pouvant être commutées par des interrupteurs commandés par des cellules mémoire non volatiles. Egalement, le brevet US 4,814,640 décrit un composant programmable comprenant une pluralité de composants en parallèle commutés par des interrupteurs commandés par des cellules mémoires programmables.

Le document DE-A-28 51 789 décrit en relation avec sa figure 7 un amplificateur de signal alternatif comprenant un transistor recevant sur sa grille une tension continue de polarisation, sur sa source une tension d'amplification, sur son drain un signal alternatif à amplifier, le signal alternatif à amplifier étant renvoyé sur la grille du transistor par l'intermédiaire d'une capacité et se superposant à la tension de polarisation.

Le document EP-A-0 281 142 décrit en relation avec sa figure 4 une étiquette électronique comprenant un circuit résonant pour recevoir par induction électromagnétique une tension alternative constituant la source d'énergie du circuit, le circuit résonant comprenant une capacité commutée par un interrupteur piloté par des données série NRZ, la capacité commutée permettant de modifier la fréquence de résonance du circuit résonnant pour envoyer les données NRZ par modulation de phase à un système de lecture/écriture de l'étiquette électronique.

Le document EP-A-0 615 136 décrit un transpondeur électronique selon le préambule de la revendication 1, comprenant un circuit résonant pour recevoir par induction électromagnétique une tension alternative constituant la source d'énergie du transpondeur, et des capacités d'accord programmables commutables par des interrupteurs afin de modifier la fréquence de résonance en fonction d'une valeur mémorisée dans le transpondeur.

Un objectif de la présente invention est d'introduire une capacité programmable dans le circuit résonant LC d'une puce électronique sans contact, afin d'accorder le circuit LC par programmation de la capacité au moment de la mise en service de la puce.

Un objectif plus particulier de la présente invention est de prévoir un commutateur programmable qui puisse commuter des tensions alternatives, notamment des tensions alternatives de valeur plus élevée que la tension normale de fonctionnement d'un circuit intégré.

Cet objectif est atteint par la prévision d'un circuit intégré conforme à la revendication 1.

Les caractéristiques et avantages ainsi que d'autres de la présente invention seront exposés plus en détail dans la description suivante d'un commutateur programmable selon la présente invention et d'un exemple d'application selon l'invention de ce commutateur à la réalisation d'une capacité programmable et d'un circuit résonant, en relation avec les figures jointes parmi lesquelles :

- la figure 1 précédemment décrite représente une capacité ajustable classique,
- la figure 2 représente schématiquement un commutateur programmable,
- la figure 3 représente un exemple de réalisation du commutateur de la figure 2,
- la figure 4 représente un autre exemple de réalisation du commutateur de la figure 2,
- la figure 5 représente un circuit résonant LC selon l'invention, comprenant des commutateurs programmables représentés sous forme de blocs,
- la figure 6 est le schéma électrique d'un commutateur programmable selon l'invention,
- la figure 7 représente de façon détaillée un élément du commutateur de la figure 6,
- la figure 8 est le schéma électrique d'un circuit permettant la programmation ou la mise en service d'un commutateur selon l'invention, et
- la figure 9 représente le circuit résonant d'une puce électronique selon l'invention.

La figure 2 représente schématiquement un commutateur programmable 1. Essentiellement, le commutateur 1 comporte entre son entrée E et sa sortie S un interrupteur 2 dont l'état fermé ou ouvert est déterminé par une cellule programmable 3 à mémoire rémanente. Une tension de lecture $V_{rd}$ ou un courant de lecture $I_{rd}$ est appliqué à la cellule 3 qui délivre une tension $V_{ce}$, ou "tension de cellule", utilisée pour commander l'interrupteur 2. Par convention, une cellule mémoire est dite "programmée" lorsqu'elle est naturellement passante, et "effacée" lorsqu'elle est naturellement non passante. Ainsi, selon l'état de la cellule, la tension de cellule $V_{ce}$ est nulle ou non nulle et l'interrupteur 2 est fermé ou ouvert.

La figure 3 représente un exemple de réalisation d'un commutateur programmable 5 dans lequel la cellule mémoire 3 prend la forme d'un transistor à grille flottante 6, et l'interrupteur 2 la forme d'un transistor MOS 7. La grille G du transistor 6 est ramenée sur sa source S qui est connectée à la masse. Le drain D reçoit la tension de lecture $V_{rd}$ (ou un courant de lecture $I_{rd}$) et est connecté à la grille G du transistor 7. Le drain D et la source S du transistor 7 forment l'entrée E et la sortie S du commutateur 5. Le transistor 6 peut être programmé de façon classique, par application d'une haute tension $V_{pp}$ de l'ordre de 12 à 20 V entre son drain D et sa grille G ou effacé par application de la haute tension $V_{pp}$ entre sa grille G et sa source S. Quand le transistor 6 est dans l'état programmé, des charges électriques sont piégées dans la grille flottante et sa tension de seuil VT est négative, par exemple de l'ordre de -4V. Le transistor 6 est alors naturellement passant et son drain D se trouve connecté à la masse lorsque la tension de lecture $V_{rd}$ est appliquée. La tension de cellule $V_{ce}$ (ici la tension du drain D du transistor 6) est nulle, et le transistor-interrupteur 7 bloqué (interrupteur ouvert). Inversement, quand le transistor 6 est dans l'état effacé, la tension de seuil VT est positive, par exemple de l'ordre de + 6V. Le transistor 6 est naturellement bloqué, son drain D ne conduisant pas. La tension de cellule $V_{ce}$ est égale à la tension de lecture $V_{rd}$ et le transistor-interrupteur 7 est passant (interrupteur fermé).

Le commutateur programmable décrit ci-dessus peut bien entendu être réalisé à partir de tout autre type de cellule mémoire. Par exemple, sur la figure 4, une cellule mémoire 8 est réalisée à partir d'un transistor MOS 9 dont la grille est polarisée par une capacité 10 dans laquelle peuvent être piégées des charges électriques. Egalement, des cellules programmables électriquement et effaçables au moyen d'une lumière ultraviolette peuvent être utilisées.

L'application d'un commutateur programmable au réglage de la fréquence de résonance du circuit LC d'une puce électronique alimentée par induction est un aspect de la présente invention.

Ainsi, la figure 5 représente une capacité programmable 20 comprenant une pluralité de capacités C1, C2,... Ci connectées en parallèle entre deux bornes communes AC1, AC2 par l'intermédiaire d'une pluralité de commutateurs programmables 11-1, 11-2,...11-i. Une capacité primaire Cm représentée en pointillés peut être prévue, selon la marge d'ajustage recherchée. La capacité 20 est associée à une bobine L pour former le circuit résonant LC d'une puce électronique. Ce circuit résonant permet à la puce de recevoir par induction électromagnétique une tension alternative $V_{ac}$ servant de source d'énergie électrique et, accessoirement, de porteuse pour l'émission et la réception de données. Grâce à la présente invention, l'accord du circuit LC peut être réalisé une fois la bobine connectée et la puce sous tension, de manière à prendre en compte les erreurs sur la valeur de la bobine L et des capacités parasites de la puce. De plus, l'accord peut être réalisé automatiquement par un bloc électronique 12 intégré dans la puce, qui lit la tension alternative $V_{ac}$ sur les bornes AC1 et AC2 et programme automatiquement les commutateurs 11-1 à 11-i jusqu'à obtenir la tension alternative $V_{ac}$ la plus élevée, la bobine L étant plongée dans un champ magnétique alternatif FLD. La présente invention propose donc, avantageusement, d'accorder le circuit résonant LC une fois la puce séparée du wafer, la bobine L soudée à la puce, et le tout assemblé sur un support ou dans un boîtier.

Dans une telle application, un problème peut surgir si les commutateurs 11 reçoivent entre leurs entrées E et leurs sorties S une tension alternative $V_{ac}$ présentant une valeur crête supérieure à la tension de lecture $V_{rd}$. Dans ce cas, la tension de grille $V_G$ du transistor-interrupteur 7 (figure 3) devient en effet inférieure à la tension de seuil de conduction VT au cours d'une alternance de la tension $V_{ac}$, et le transistor 7 se bloque. Par exemple, dans le cas d'une carte à puce sans contact ou d'une étiquette électronique recevant des données numériques par l'intermédiaire du circuit résonant LC de la figure 5, la tension induite $V_{ac}$ apparaissant entre les bornes AC1, AC2 peut atteindre les 18 V crête à crête. Par contre, la tension de lecture $V_{rd}$ d'une cellule mémoire n'est classiquement que de l'ordre de 3 à 4 V lorsqu'elle est générée à partir de la tension d'alimentation d'un circuit intégré.

Selon l'invention, on pallie cet inconvénient en interposant entre le transistor-interrupteur 7 et la cellule 6 des moyens de commande du transistor 7 recevant en entrée la tension de cellule $V_{ce}$ et délivrant une tension de commande du transistor 7 supérieure à la tension de cellule $V_{ce}$. Ces moyens de commande pourraient par exemple prendre la forme d'un circuit survolteur comme une pompe de charges. Toutefois, une pompe de charges présente généralement un temps de mise en service assez long et se prête mal à l'application selon l'invention, le circuit résonant devant être opérationnel rapidement après l'apparition de la tension de lecture $V_{rd}$.

La figure 6 représente un mode de réalisation 11 selon l'invention des commutateurs 11-1 à 11-i de la figure 5 ne présentant pas cet inconvénient. On y retrouve le transistor à grille flottante 6 et le transistor-interrupteur 7 déjà décrits. La source S du transistor 7 est connectée à la borne AC1 par l'intermédiaire d'une capacité Ci et reçoit une alternance $V_{c1}$ de la tension alternative $V_{ac}$. Le drain D est connecté à la borne AC2 et reçoit l'autre alternance $V_{c2}$. Le drain D du transistor à grille flottante 6 est connecté sur l'entrée IN d'un étage 31 adaptateur de tension qui sera décrit plus loin. L'entrée IN de l'étage 31 reçoit une tension d'entrée $V_{in}$ égale à la tension de cellule $V_{ce}$ qui est elle-même égale à la tension de lecture $V_{rd}$ quand le transistor 6 est dans l'état effacé. La sortie OUT de l'étage 31 délivre une tension $V_{out}$ appliquée sur la grille G du transistor 7 par l'intermédiaire d'un transistor MOS 32 fonctionnant comme une diode. Enfin, la grille G du transistor 7 est connectée à une capacité de survoltage 33 dont le rôle sera décrit plus loin. La borne libre de la capacité 33 est connectée au drain D du transistor 33 afin de recevoir l'alternance $V_{c2}$.

L'étage adaptateur 31, représenté en détail sur la figure 7, comprend deux bras parallèles 34, 37 dont une extrémité reçoit l'alternance $V_{c1}$ et dont l'autre extrémité est connectée à la masse. Le bras 34 comprend en série un transistor PMOS 35 et un transistor NMOS 36 et le bras 37 un transistor PMOS 38 et NMOS 39. La grille G du transistor 35 est connectée aux drains D des transistors 38, 39 et la grille du transistor 38 est connectée au drain D du transistor 35. La tension $V_{out}$ est prélevée sur les drains D des transistors 38, 39 qui sont par ailleurs reliés à la masse par l'intermédiaire d'un transistor NMOS 40 recevant sur sa grille G l'alternance $V_{c2}$ de la tension $V_{ac}$. Enfin, la tension d'entrée $V_{in}$ est appliquée sur la grille G du transistor 36 et une tension $V_{nin}$ inverse de la tension $V_{in}$ est appliquée sur la grille G du transistor 39. La tension $V_{nin}$ est prélevée sur le drain D d'un transistor NMOS dont la source S est connectée à la masse, ce transistor étant polarisé par la tension de lecture $V_{rd}$ et piloté par la tension $V_{in}$. Ainsi, quand $V_{in}$ est à 1 (c'est-à-dire égale à la tension de lecture $V_{rd}$) la tension $V_{nin}$ est à 0 (c'est-à-dire à la masse) et inversement.

Quand la tension $V_{in}$ est à 1 (transistor 6 dans l'état effacé) les transistors 36 et 38 sont passants et la tension de sortie $V_{out}$ recopie l'alternance $V_{c1}$ pendant la durée de cette alternance et est mise à 0 pendant l'alternance $V_{c2}$ par le transistor 40 qui devient conducteur. Quand la tension $V_{in}$ est à 0 (transistor 6 dans l'état programmé) le transistor 39 est passant et la sortie $V_{out}$ maintenue à 0, le transistor-interrupteur 7 étant ainsi bloqué (ce qui correspond à la coupure d'une piste conductrice dans l'art antérieur). Quand la tension $V_{in}$ est à 1, la fermeture du transistor-interrupteur 7 est assurée par la capacité de survoltage 33 qui se trouve chargée à la valeur

$$[V_{c1max} - Vt],$$

$V_{c1max}$ étant la valeur crête de l'alternance $V_{c1}$ et Vt la tension de seuil du transistor-diode 32, dont le rôle est d'empêcher la capacité 33 de se décharger.

Au cours d'une alternance $V_{c1}$, la tension de grille $V_G$ du transistor 7 est ainsi portée à un niveau N1 égal à

$$N1 = [V_{c1max} - Vt]$$

et, au cours d'une alternance $V_{c2}$, à un niveau N2 égal à

$$N2 = N1 + V_{c2}$$

car la capacité de survoltage reçoit sur son autre borne l'alternance $V_{c2}$.

Ainsi, le transistor-interrupteur 7 est toujours passant et fonctionne de façon bidirectionnelle quelle que soit l'amplitude de la tension alternative $V_{ac}$, la tension de grille $V_G$ évoluant proportionnellement à la tension crête $V_{c1max}$. Pour fixer les idées, le fonctionnement du commutateur 11 est résumé dans le tableau ci-après.

Bien entendu, le fonctionnement du commutateur 11 peut être inversé en attaquant la grille G du transistor 39 avec la tension $V_{in}$ et celle du transistor 36 avec la tension $V_{nin}$. Dans ce cas, le commutateur est ouvert (non passant) quand $V_{in}$ est à 1 (transistor 6 dans l'état effacé) et fermé (passant) quand $V_{in}$ est à 0 (transistor 6 programmé).

Tableau

| | valeur de $V_{out}$ | | valeur de $V_G$ du transistor 7 | |
|---|---|---|---|---|
| | alternance $V_{c1}$ | alternance $V_{c2}$ | alternance $V_{c1}$ | alternance $V_{c2}$ |
| $V_{in} = 0$ | 0 | 0 | 0 | 0 |
| $V_{in} = 1$ | $V_{c1}$ | 0 | $V_{c1max} - V_T$ | $V_{c1max} - V_t + V_{c2}$ |

La capacité 33 est dite "capacité de survoltage" (ou capacité "boost") car on applique sur sa borne libre l'alternance $V_{c2}$ afin d'amener la tension de grille $V_G$ au niveau N2, ce qui permet de rendre passant le transistor 7 au cours de l'alternance $V_{c2}$, comme on vient de le voir.

Toutefois, selon une variante, la capacité 33 peut être utilisée comme un simple intégrateur, sans la fonction de survoltage. Dans ce cas, la borne libre de la capacité 33 est connectée à la masse et le transistor 7 n'est passant que pendant l'alternance Vc1. Un deuxième transistor-interrupteur 7, piloté par un deuxième étage adaptateur 31 délivrant l'alternance $V_{c2}$ sur sa sortie OUT, peut alors être prévu pour laisser traverser l'alternance Vc2. Une telle structure "push-pull" à deux transistors-interrupteurs 7 et deux étages adaptateurs 31 peut être utilisée quand le circuit qui vient d'être décrit est réalisé au moyen d'interrupteurs 7 à un seul sens de conduction, par exemple des transistors bipolaires.

Enfin, et comme illustré sur la figure 6, un transistor 42 est prévu pour maintenir à 0 la tension $V_G$ du transistor 7 quand le signal $V_{in}$ est à 0. Ce transistor 42 est connecté entre la grille du transistor 7 et la masse et est par exemple piloté par la tension $V_{nin}$ déjà décrite.

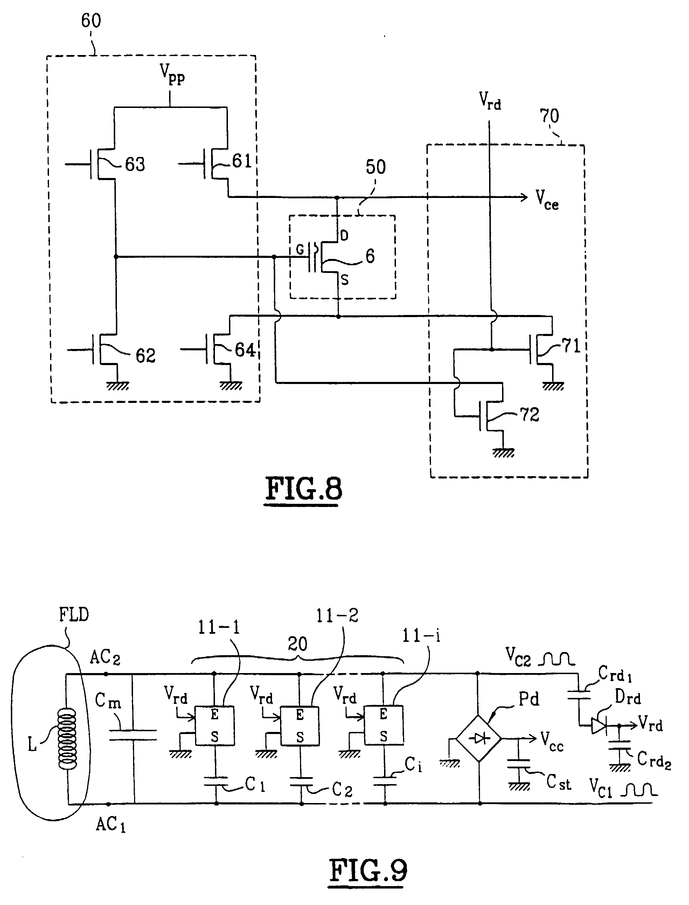

La figure 8 représente un exemple de connexion, dans un circuit intégré, d'une cellule mémoire 50 comprenant le transistor à grille flottante 6 déjà décrit. On distingue un premier groupe 60 de quatre interrupteurs 61, 62, 63, 64 pour la programmation ou l'effacement de la cellule 50 et un groupe 70 de deux interrupteurs 71, 72 pour la lecture de la cellule. A la programmation, le transistor à grille flottante 6 reçoit sur son drain D une haute tension $V_{pp}$ appliquée au moyen du transistor 61 et sa grille G est connectée à la masse par le transistor 62, les transistors 63, 64 étant non conducteurs. A l'effacement, le transistor à grille flottante 6 reçoit sur sa grille G la haute tension $V_{pp}$ appliquée au moyen du transistor 63 et sa source S est connectée à la masse par le transistor 64, les transistors 61 et 62 étant non conducteurs. Enfin, à la lecture, la grille G et la source S du transistor à grille flottante 6 sont connectées à la masse par les transistors 71, 72 dont les grilles G reçoivent la tension de lecture $V_{rd}$. Simultanément, la tension de lecture $V_{rd}$ est appliquée au drain D du transistor 6, sur lequel on trouve la tension de cellule $V_{ce}$, égale à 0 ou à $V_{rd}$ selon l'état du transistor. Bien entendu, la tension de lecture $V_{rd}$ est inhibée pendant les périodes de programmation ou d'effacement. De plus, en pratique, les cellules mémoire de plusieurs commutateurs selon l'invention peuvent être rangées en lignes et être accessibles par l'intermédiaire de circuits multiplexeurs pour l'application de la haute tension $V_{pp}$ de programmation ou d'effacement.

La figure 9 représente un circuit résonant LC d'une puce sans contact alimentée par induction électromagnétique. Le circuit LC est identique à celui décrit en figure 5 et on y retrouve la capacité programmable 20 comprenant les commutateurs 11-1 à 11-i selon l'invention. La puce est alimentée par une tension $V_{cc}$ délivrée par un pont redresseur Pd à diodes recevant en entrée la tension alternative induite $V_{ac}$. Une capacité de filtrage $C_{st}$ de forte valeur est prévue à la sortie du pont redresseur Pd afin de constituer un réservoir de charges apte à stabiliser la tension $V_{cc}$ en cas de mauvaise réception de l'énergie.

On supposera maintenant que le circuit LC a déjà été accordé par une programmation adéquate des commutateurs 11-1 à 11-i, par exemple au moyen du bloc électronique 12 de la figure 5, et que la puce se trouve soudainement plongée dans un champ magnétique alternatif FLD après avoir été mise hors tension.

Le problème qui se pose alors est que les commutateurs 11-1 à 11-i doivent être opérationnels pour que le circuit LC soit accordé à la fréquence d'oscillation du champ magnétique. Or, les commutateurs 11-à 11-i ne sont opérationnels qu'à l'instant où la tension de lecture $V_{rd}$ leur est appliquée, et la tension d'alimentation $V_{cc}$ n'apparaît que lentement en raison du temps nécessaire à la charge de la capacité $C_{st}$. Ainsi, si la tension $V_{cc}$ est utilisée comme tension de lecture $V_{st}$ des commutateurs 11-1 à 11-i, la mise sous tension de la puce risque de se faire très lentement. Au pire, si le circuit LC est fortement désaccordé avant la mise en service des commutateurs, et que la tension induite

$V_{ac}$ est insuffisante pour charger la capacité $C_{st}$, la tension d'alimentation $V_{cc}$ peut ne pas apparaître.

Pour pallier cet inconvénient, la présente invention propose de prévoir un circuit redresseur auxiliaire pour délivrer la tension de lecture $V_{rd}$ des commutateurs. Ce circuit redresseur auxiliaire comporte une capacité de filtrage de faible valeur de manière que la tension de lecture $V_{rd}$ apparaisse rapidement dès les premières oscillations de la tension induite $V_{ac}$, même si ces oscillations sont de faible énergie et le circuit LC mal accordé. Un mode de réalisation particulièrement simple du circuit auxiliaire, représenté sur la figure 9, consiste à faire un redressement simple alternance de la tension induite $V_{ac}$ au moyen d'une diode $D_{rd}$ et d'une capacité $C_{rd2}$ de faible valeur. De préférence, la diode $D_{rd}$ est connectée à l'une ou l'autre des bornes AC1, AC2 de la bobine par l'intermédiaire d'une capacité $C_{rd1}$ permettant de limiter le courant de lecture $I_{rd}$ envoyé dans les cellules mémoire des commutateurs 11-1 à 11-i.

Il apparaîtra clairement à l'homme de l'art que la présente invention est susceptible de nombreuses variantes de réalisations et perfectionnements. En particulier, il est envisageable que chaque commutateur programmable selon l'invention comprenne plusieurs cellules en série, en parallèle, ou en série-parallèle, si un haut niveau de fiabilité est exigé. Egalement, on pourra trouver dans un commutateur selon l'invention plusieurs interrupteurs fonctionnant de façon conjointe ou complémentaire, comme décrit plus haut.

## Revendications

1. Circuit intégré comprenant un circuit résonant (L, 20) devant être accordé à une fréquence de résonance prédéterminée pour recevoir par induction électromagnétique une tension alternative ($V_{ac}$) constituant la source d'énergie du circuit intégré, le circuit résonant comprenant au moins une capacité d'accord (C1-Ci) commutable au moyen d'un commutateur programmable (11) comprenant un moyen interrupteur (7) pour commuter la tension alternative ($V_{ac}$), une cellule mémoire (6) et des moyens (31, 32, 33, 42) de commande du moyen interrupteur (7) agencés pour ouvrir ou fermer le moyen interrupteur (7) en fonction de l'état de programmation ou d'effacement de la cellule mémoire (6), caractérisé en ce que les moyens (31, 32, 33, 42) de commande du moyen interrupteur (7) sont alimentés par la tension alternative ($V_{ac}$) et comprennent des moyens (31, 32) pour délivrer, selon l'état de programmation de la cellule mémoire (6), au moins une première alternance ($V_{c1}$) du signal alternatif ($V_{ac}$) vers l'électrode de commande (G) du moyen interrupteur (7).

2. Circuit intégré selon la revendication 1, dans lequel la sortie des moyens (31, 32) pour délivrer au moins une première alternance ($V_{c1}$) du signal alternatif ($V_{ac}$) est connectée à une première borne d'une capacité (33) dont la deuxième borne est agencée pour recevoir l'autre alternance ($V_{c2}$) du signal alternatif ($V_{ac}$).

3. Circuit intégré selon la revendication 1, dans lequel la sortie des moyens (31, 32) pour délivrer au moins une première alternance ($V_{c1}$) du signal alternatif ($V_{ac}$) est connectée à une première borne d'une capacité (33) dont la deuxième borne est connectée à la masse du circuit intégré.

4. Circuit intégré selon l'une des revendications précédentes, dans lequel le moyen interrupteur comprend un transistor MOS (7).

5. Circuit intégré selon l'une des revendications précédentes, dans lequel la cellule mémoire (6) est programmable et effaçable électriquement.

6. Circuit intégré selon l'une des revendications précédentes, dans lequel la cellule mémoire comprend un transistor à grille flottante (6).

7. Circuit intégré selon l'une des revendications précédentes, comportant des moyens ($C_{rd}$, $D_{rd}$) de redressement rapide à faible capacité de filtrage ($C_{rd}$) de la tension alternative ($V_{ac}$), pour délivrer une tension de lecture ($V_{rd}$) de la cellule mémoire (6).

8. Circuit intégré selon l'une des revendications précédentes, comprenant des moyens (12, 60, 70) pour programmer automatiquement le commutateur programmable (11) de manière à recevoir la tension alternative ($V_{ac}$) la plus élevée.

## Patentansprüche

1. Integrierte Schaltung, umfassend eine Resonanzschaltung (L, 20), die auf eine vorbestimmte Resonanzfrequenz abgestimmt werden muss, um durch elektromagnetische Induktion eine Wechselspannung ($V_{ac}$) zu empfangen, die die Energiequelle der integrierten Schaltung bildet, wobei die Resonanzschaltung mindestens eine Abstimmkapazität (C1-Ci) umfasst, die mittels einer programmierbaren Schalteinrichtung (11), die ein Unterbrechermittel (7) umfasst, um die Wechselspannung ($V_{ac}$) zu schalten, schaltbar ist, eine Speicherzelle (6) und Mittel (31, 32, 33, 42) zur Steuerung des Unterbrechermittels (7), die angeordnet sind, um das Unterbrechermittel (7) abhängig vom Zustand der Programmierung oder Löschung der Speicherzelle (6) zu öffnen oder zu schließen, dadurch gekennzeichnet, dass die Mittel (31, 32, 33, 42) zur Steuerung des Unterbrechermittels (7) von der Wechselspannung ($V_{ac}$) versorgt werden, und Mittel (31, 32) umfassen, um gemäß dem Zustand der Programmierung der Speicherzelle (6) zumindest einen ersten Wechsel ($V_{c1}$) des Wechselsignals ($V_{ac}$) an die Steuerelektrode (G) des Unterbrechermittels (7) zu liefern.

2. Integrierte Schaltung nach Anspruch 1, bei welcher der Ausgang der Mittel (31, 32) zur Lieferung zumindest eines ersten Wechsels ($V_{c1}$) des Wechselsignals ($V_{ac}$) verbunden ist mit einem ersten Anschluss eines Kondensators (33), dessen zweiter Anschluss angeordnet ist, um den anderen Wechsel ($V_{c2}$) des Wechselsignals ($V_{ac}$) zu empfangen.

3. Integrierte Schaltung nach Anspruch 1, bei welchem der Ausgang der Mittel (31, 32) zur Lieferung zumindest eines ersten Wechsels ($V_{c1}$) des Wechselsignals ($V_{ac}$) verbunden ist mit einem ersten Anschluss eines Kondensators (33), dessen zweiter Anschluss mit der Masse der integrierten Schaltung verbunden ist.

4. Integrierte Schaltung nach einem der vorangegangenen Ansprüche, bei welchem das Unterbrechermittel einen MOS-Transistor (7) umfasst.

5. Integrierte Schaltung nach einem der vorangegangenen Ansprüche, bei welchem die Speicherzelle (6) elektrisch programmierbar und löschbar ist.

6. Integrierte Schaltung nach einem der vorangegangenen Ansprüche, bei welchem die Speicherzelle einen Transistor mit schwebendem Gate (6) umfasst.

7. Integrierte Schaltung nach einem der vorangegangenen Ansprüche, umfassend Mittel ($C_{rd}$, $D_{rd}$) zur schnellen Gleichrichtung der Wechselspannung ($V_{ac}$) mit kleiner Filterkapazität ($C_{rd}$), um eine Lesespannung ($V_{rd}$) der Speicherzelle (6) zu liefern.

8. Integrierte Schaltung nach einem der vorangegangenen Ansprüche, umfassend Mittel (12, 60, 70) zur automatischen Programmierung der programmierbaren Schalteinrichtung (11), so dass die höchste Wechselspannung ($V_{ac}$) empfangen wird.

**Claims**

1. Integrated circuit including a resonant circuit (L, 20) designed to be tuned to a predetermined resonance frequency for receiving by electromagnetic induction an alternating voltage ($V_{ac}$) constituting the energy source of the integrated circuit, the resonant circuit including at least one tuning capacitor (C1-Ci) capable of being switched by means of a programmable switch (11) having interrupter means (7) for switching the alternating voltage ($V_{ac}$), a memory cell (6) and means (31, 32, 33, 42) for controlling the interrupter means (7) designed to open or close the interrupter means (7) as a function of the state of programming or erasing of the memory cell (6), characterised in that the means (31, 32, 33, 42) for controlling the interrupter means (7) are supplied with the alternating voltage ($V_{ac}$) and have means (31, 32) for delivering, according to the state of programming of the memory cell (6), at least a first half-cycle ($V_{c1}$) of the alternating signal ($V_{ac}$) to the control electrode (G) of the interrupting means (7).

2. Integrated circuit according to Claim 1, in which the output of the means (31, 32) for delivering at least a first half-cycle ($V_{c1}$) of the alternating signal ($V_{ac}$) is connected to a first terminal of a capacitor (33) of which the second terminal is designed to receive the other half-cycle ($V_{c2}$) of the alternating signal ($V_{ac}$).

3. Integrated circuit according to Claim 1, in which the output of the means (31, 32) for delivering at least a first half-cycle ($V_{c1}$) of the alternating signal ($V_{ac}$) is connected to a first terminal of a capacitor (33) of which the second terminal is connected to the earth of the integrated circuit.

4. Integrated circuit according to one of the foregoing claims, in which the interrupter means comprise a MOS transistor (7).

5. Integrated circuit according to one of the foregoing claims, in which the memory cell (6) is electrically programmable and erasable.

6. Integrated circuit according to one of the foregoing claims, in which the memory cell comprises an insulated gate transistor (6).

7. Integrated circuit according to one of the foregoing claims, comprising means ($C_{rd}$, $D_{rd}$) for the rapid rectification and low-capacity filtering ($C_{rd}$) of the alternating voltage ($V_{ac}$), for delivering a reading voltage ($V_{rd}$) for the memory cell (6).

8. Integrated circuit according to one of the foregoing claims, including means (12, 60, 70) for automatically programming the programmable switch (11) in such a way as to receive the highest alternating voltage ($V_{ac}$).

FIG.1

FIG.2

FIG.3

FIG.4

FIG.5

FIG.6

FIG.7

## FIG.8

## FIG.9